# EUROPEAN PATENT SPECIFICATION

(11) **EP 2 551 917 B1**
(45) Date of publication and mention of the grant of the patent: **09.05.2018**
(21) Application number: 11759161.0
(22) Date of filing: 03.03.2011
(51) Int. Cl.: H01L 31/049, B32B 7/12, B32B 27/08, B32B 27/20, B32B 27/32, B32B 27/36, B32B 17/10

(54) **SOLAR-CELL BACKSIDE PROTECTION SHEET AND SOLAR-CELL MODULE PROVIDED WITH SAME**
SCHUTZFOLIE FÜR SOLARZELLEN-RÜCKSEITEN UND DAMIT AUSGESTATTETES SOLARZELLENMODUL
FEUILLE DE PROTECTION DU CÔTÉ ARRIÈRE D'UNE CELLULE SOLAIRE ET MODULE À CELLULE SOLAIRE MUNI DE CELLE-CI

(30) Priority: 23.03.2010 JP 2010065600
(43) Date of publication of application: 30.01.2013
(73) Proprietor: Toyo Aluminium Kabushiki Kaisha, Osaka-shi, Osaka 541-0056 (JP)
(72) Inventor: KITAMORI, Yoshinobu, Osaka-shi Osaka 541-0056 (JP); YONEDA, Atsushi, Osaka-shi Osaka 541-0056 (JP); SARUWATARI, Masataka, Osaka-shi Osaka 541-0056 (JP)
(74) Representative: Grünecker Patent- und Rechtsanwälte PartG mbB
(86) International application number: PCT/JP2011/054843
(87) International publication number: WO 2011/118353

(56) References cited:
- EP-A1- 2 117 050
- EP-A1- 2 613 363
- WO-A1-2011/090023
- JP-A- 2002 069 399
- JP-A- 2006 210 405
- JP-A- 2006 270 025
- JP-A- 2007 129 015
- JP-A- 2008 085 294
- JP-A- 2008 211 034
- US-A1- 2006 166 023
- US-A1- 2009 173 384

## Description

### TECHNICAL FIELD

The present invention relates generally to a back side protective sheet for a solar cell disposed on a back side of a solar cell module and to a solar cell module comprising the back side protective sheet. More particularly, the present invention relates to a back side protective sheet for a solar cell, which has weather resistance, and to a solar cell module comprising the back side protective sheet.

### BACKGROUND ART

Because of the nature of a solar cell module, it is often the case that a solar cell module is installed outdoors. Therefore, in order to protect solar cell elements, electrodes, wires, and the like, for example, a transparent glass plate is disposed on a front side thereof and, for example, a laminated sheet of aluminum foil and a resin film, a laminated sheet of resin films, or the like is disposed on a back side thereof.

A back side protective sheet for a solar cell is adhered, by using a hot-press, to an outer surface of an ethylene-vinyl acetate copolymer (EVA) resin as a filler used to seal solar cell elements. For example, Japanese Patent Application Laid-Open Publication No. 2008-211034 (Patent Literature 1) has proposed a back side protective sheet for a solar cell capable of enhancing adherence to the EVA resin as the filler used to seal the solar cell elements, of maintaining the weather resistance over a long period of time, and of reducing a weight. This back side protective sheet for a solar cell includes: a first film which contains linear low-density polyethylene having a density greater than or equal to 0.91 g/cm³ and less than or equal to 0.93 g/cm³; and a second film which contains polyvinylidene fluoride and polymethyl methacrylate and is laminated on the first film.

However, as problems regarding the weather resistance of the back side protective sheet for a solar cell, which should be solved, in addition to a problem of a reduction in adherence to the EVA resin, there are a problem of poor appearance caused by yellow discoloration of the back side protective sheet for a solar cell and a problem of a reduction in an output.

For example, Japanese Patent Application Laid-Open Publication No. 2008-270647 (Patent Literature 2) has proposed a back side protective sheet for a solar cell, which has transparency and is capable of suppressing a reduction in adherence of an inside of the sheet and yellow discoloration of the sheet even with the back side protective sheet for a solar cell being installed outdoors. In this back side protective sheet for a solar cell formed by sequentially laminating at least an inorganic oxide layer, an adhesive layer, and an electrical insulating layer on a surface of at least one side of a transparent base material film, the above-mentioned transparent base material film is formed of polyethylene naphthalate, the above-mentioned inorganic oxide layer has a film thickness greater than or equal to 50 Å and less than or equal to 3000Å, and the above-mentioned adhesive layer contains an organic ultraviolet absorbing agent greater than or equal to 0.1 parts by weight and less than or equal to 10 parts by weight with respect to 100 parts by weight of a solid content of the resin which constitutes the adhesive layer.

However, there is the concern regarding the hazardousness caused on the human body by the organic ultraviolet absorbing agent. In addition, since as compared with an inorganic ultraviolet absorbing agent, the organic ultraviolet absorbing agent is inferior in temporal and environmental stability, decomposition or the like of the ultraviolet absorbing agent may be caused due to aging.

Furthermore, upon the lamination process conducted during manufacturing of the back side protective sheet, for the purpose of enhancing mutual adhesiveness of resin films, surfaces of the resin films are subjected to a corona treatment. The corona treatment which is one of surface treatments and employs plasma discharge has the problem of decomposing unstable substances because high energy is applied to the films. Because it is likely that the organic ultraviolet absorbing agent contained in the resin films vaporizes or decomposes when coming into a high-temperature state, the organic ultraviolet absorbing agent may be adversely affected by the corona treatment on the spot, or early aged deterioration thereof may occur. Accordingly, since in the conducted corona treatment, the decomposition or the like of the ultraviolet absorbing agent is caused, it is likely that intrinsic properties of the ultraviolet absorbing agent cannot be sufficiently exhibited.
An encapsulant for a photovoltaic module for the prevention of clouding is known from the U. S. Patent Application No. US 2009/173384 A1 (Patent Literature 3), wherein the encapsulant comprises a metallocene based LLDE and an UV-absorbent used in a front side or a backside filler layer. Japanese Patent Application Laid-Open Publication No. 2002-069399 A (Patent Literature 4) discloses an environmentally friendly multilayer adhesive film comprising a colored resin layer, a substrate layer and an adhesive layer.

### CITATION LIST

### PATENT LITERATURE

Patent Literature 1: Japanese Patent Application Laid-Open Publication No. 2008-211034
Patent Literature 2: Japanese Patent Application Laid-Open Publication No. 2008-270647
Patent Literature 3: U. S. Patent Application No. US 2009/173384 A1
Patent Literature 4: Japanese Patent Application Laid-Open Publication No. 2002-069399

### SUMMARY OF THE INVENTION

### TECHNICAL PROBLEM

Therefore, objects of the present invention are to provide a back side protective sheet for a solar cell capable of enhancing adherence to an EVA resin as a filler used to seal solar cell elements and of preventing yellow discoloration over a long period of time; and a solar cell module including the back side protective sheet for a solar cell.

### SOLUTION TO PROBLEM

A back side protective sheet for a solar cell according to the present invention is a back side protective sheet for a solar cell, disposed on a back side of a solar cell module, and includes: a first film containing linear low-density polyethylene having a density greater than or equal to 0.91 g/cm³ and less than or equal to 0.93 g/cm³ and an inorganic ultraviolet absorbing agent; and a second film laminated on the first film, with a urethane adhesive layer being interposed therebetween. An average particle diameter of the inorganic ultraviolet absorbing agent is greater than or equal to 0.1 µm and less than or equal to 5 µm. The first film contains the inorganic ultraviolet absorbing agent greater than or equal to 0.1% by mass and less than or equal to 30% by mass.

It is preferable that in the back side protective sheet for a solar cell according to the present invention, the inorganic ultraviolet absorbing agent is one kind selected from the group consisting of a titanium oxide, a zinc oxide, a zirconium oxide, a calcium carbonate, a cerium oxide, silica, an iron oxide, and carbon.

In addition, it is preferable that in the back side protective sheet for a solar cell according to the present invention, an ultraviolet transmittance of the first film is less than or equal to 20%.

Furthermore, it is preferable that in the back side protective sheet for a solar cell according to the present invention, a thickness of the first film is greater than or equal to 5 µm and less than or equal to 200 µm.

It is preferable that in the back side protective sheet for a solar cell according to the present invention, the second film includes: polyethylene terephthalate disposed on a side of the first film; and a fluorine-based film laminated on the polyethylene terephthalate film.

A solar cell module according to the present invention includes: a filler being constituted of an ethylene-vinyl acetate copolymer resin being disposed to seal solar cell elements; and the back side protective sheet for a solar cell, having any of the above-described features, which is fixedly attached on an outer surface of the filler of a back side of the solar cell module.

### ADVANTAGEOUS EFFECTS OF THE INVENTION

In a back side protective sheet for a solar cell according to the present invention, a first film containing linear low-density polyethylene having a density greater than or equal to 0.91 g/cm³ and less than or equal to 0.93 g/cm³ is excellent in adherence to a filler being constituted of an ethylene-vinyl acetate copolymer resin disposed to seal solar cell elements and is capable of maintaining the adherence over time. In addition, since temporal and environmental stability of an inorganic ultraviolet absorbing agent contained in the first film is high, decomposition is hardly caused and yellow discoloration of the back side protective sheet can be prevented over a long period of time. In particular, yellow discoloration of a urethane adhesive layer used to laminate and fixedly attach the first and second films can be prevented over a long period of time.

Hence, according to the present invention, adherence of the back side protective sheet and an EVA resin as a filler used to seal solar cell elements can be enhanced and a reduction in an output, caused by the yellow discoloration, can be prevented over a long period of time.

### BRIEF DESCRIPTION OF THE DRAWINGS

Fig. 1 is a schematic diagram illustrating a cross section structure of a solar cell module to which a back side protective sheet for a solar cell, as one embodiment according to the present invention, is applied.
Fig. 2 shows a cross section view of the back side protective sheet for a solar cell, as the one embodiment according to the present invention.

### DESCRIPTION OF EMBODIMENTS

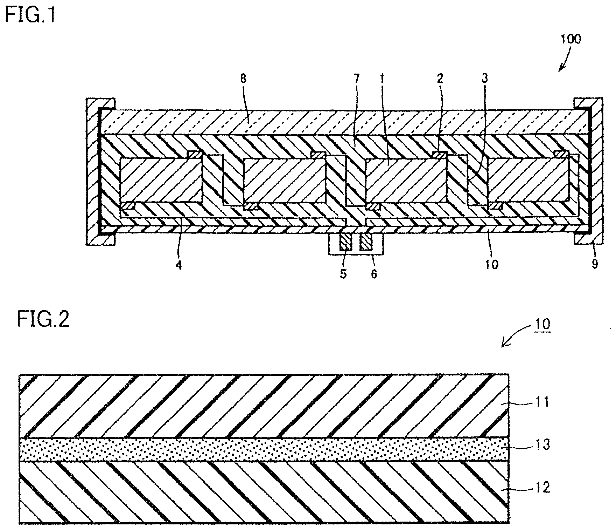

Fig. 1 is a schematic diagram illustrating a cross section structure of a solar cell module to which a back side protective sheet for a solar cell, as one embodiment according to the present invention, is applied.

As shown in Fig. 1, a multitude of solar cell elements 1 are arranged in the solar cell module 100. These solar cell elements 1 are electrically connected to each other via electrodes 2 by connection wires 3. In the whole solar cell module 100, terminals 5 are led out to a back side thereof by lead wires 4, and the terminals 5 are housed in a terminal box 6. A filler 7 constituted of an ethylene-vinyl acetate copolymer (EVA) resin is disposed to seal the multitude of solar cell elements 1. On an outer surface of the filler 7, which is located on a light receiving surface side of the solar cell module 100, a transparent glass layer 8 is fixedly attached. On an outer surface of the filler 7, which is located on an installation surface side of the solar cell module 100, the back side protective sheet 10 for a solar cell is fixedly attached. On side surfaces of the solar cell module 100, a frame member 9 formed of aluminum is attached via a sealant.

Fig. 2 shows a cross section view of the back side protective sheet for a solar cell, as the one embodiment according to the present invention.

As shown in Fig. 2, in the back side protective sheet 10 for a solar cell, a first film 11 and a second film 12 are laminated in order from an inner layer disposed on a side (inner side) relatively close to the solar cell module 100. Between the first film 11 and the second film 12, a urethane adhesive layer 13 is disposed. The first film 11 is fixedly attached so as to abut a surface of the filler 7. This attachment is conducted by using a hot-press. The second film 12 is disposed in an outermost layer of the back side protective sheet 10 for a solar cell. The first film 11 contains linear low-density polyethylene having a density greater than or equal to 0.91 g/cm³ and less than or equal to 0.93 g/cm³ and an inorganic ultraviolet absorbing agent.

### (First Film)

The first film 11 is capable of enhancing adherence to a sealant of an EVA resin or the like by using the linear low-density polyethylene having the density greater than or equal to 0.91 g/cm³ and less than or equal to 0.93 g/cm³. As the inorganic ultraviolet absorbing agent contained in the first film 11, although there are a titanium oxide, a zinc oxide, a zirconium oxide, a calcium carbonate, a cerium oxide, an aluminum oxide, silica, an iron oxide, carbon, and the like, the titanium oxide or the carbon is preferably used.

A preferable average particle diameter of the ultraviolet absorbing agent is 0.1 through 5 µm. If the average particle diameter of the ultraviolet absorbing agent exceeds 5 µm, dispersibility inside the first film 11 is worsened and thus, it is likely that an even ultraviolet absorbing effect cannot be attained. In addition, if the average particle diameter of the ultraviolet absorbing agent is less than 0.1 µm, a price per unit weight is increased.

In order for the first film 11 to sufficiently exhibit, to the back side protective sheet 10 for a solar cell, the ultraviolet absorbing effect for preventing the yellow discoloration and to maintain the adherence to the ethylene-vinyl acetate copolymer (EVA) resin, it is preferable that the first film 11 contains the inorganic ultraviolet absorbing agent whose content is greater than or equal to 0.1% by mass and less than or equal to 30% by mass. If the content of the inorganic ultraviolet absorbing agent is less than 0.1% by mass, the ultraviolet absorbing effect is not sufficient and thus, it is likely the yellow discoloration of the back side protective sheet 10 for a solar cell is caused. In addition, if the content of the inorganic ultraviolet absorbing agent exceeds 30% by mass, it is likely that the adherence to the sealant is reduced.

It is preferable that an ultraviolet transmittance of the first film 11 is less than or equal to 20%. If the ultraviolet transmittance of the first film 11 exceeds 20%, the ultraviolet absorbing effect is not sufficient and thus, it is likely that the yellow discoloration of the back side protective sheet 10 for a solar cell is caused. Although a lower limit of the ultraviolet transmittance is not particularly limited, ordinarily, the lower limit is approximately 1%.

It is preferable that a thickness of the first film 11 is greater than or equal to 5 µm and less than or equal to 200 µm in order to sufficiently contain the inorganic ultraviolet absorbing agent, and it is more preferable that the thickness of the first film 11 is greater than or equal to 30 µm and less than or equal to 180 µm. If the thickness of the first film 11 is less than 5 µm, the inorganic ultraviolet absorbing agent cannot be sufficiently contained therein.

### (Second Film)

Weather resistance and electrical insulating properties are required of the second film 12. A polyester film such as polyethylene naphthalate (PEN) and polyethylene terephthalate (PET); a fluorine-based film such as polyvinylidene fluoride (PVDF) and polyvinyl fluoride (PVF); a polyolefin film such as polyethylene and polypropylene; a polystyrene film; a polyamide film; a polyvinyl chloride film; a polycarbonate film; a polyacrylonitrile film; a polyimide film; or the like can be used. In addition, a laminated film may constitute the second film 12, instead of a single-layer film.

In a case where the laminated film constitutes the second film 12, it is preferable that a film excellent in the weather resistance and a film excellent in the electrical insulating properties are laminated. In this case, the film excellent in the electrical insulating properties is laminated on a side of the first film. As the film excellent in the weather resistance, it is preferable that the fluorine-based film, in particular, whose thickness is greater than or equal to 20 µm and less than or equal to 150 µm is used. As the film excellent in the electrical insulating properties, the polyethylene terephthalate (PET), in particular, whose thickness is greater than or equal to 100 µm and less than or equal to 250 µm is preferably used.

### (Adhesive Layer)

The first film 11 and the second film 12 are laminated by using an urethane adhesive and employing a dry lamination method. As the urethane adhesive, although there are a two-part curable urethane adhesive, a polyether urethane adhesive, a polyester polyurethane polyol adhesive, and the like, in particular, it is preferable that the two-part curable urethane adhesive is used.

The first film 11 and the second film 12 can be laminated by employing the heretofore known method. For example, as described above, a method in which the first film 11 and the second film 12 are laminated with the adhesive layer 13 interposed therebetween as shown in Fig. 2 by using the urethane adhesive and employing the dry lamination method is employed. In addition to the above-mentioned method, a co-extrusion method, an extrusion coat method, a thermal lamination method using an anchor coat agent, or the like may be adopted to laminate the first film 11 and the second film 12.

### EXAMPLES

Test samples of examples and comparison examples of the back side protective sheet for a solar cell were prepared as described below.

### (Example 1)

Titanium oxide (TiO₂) particles, as an inorganic ultraviolet absorbing agent, having an average particle diameter of 0.3 µm and a weight of 25 kg were added to a polyethylene resin (manufactured by Tamapoly Co., Ltd.) having a density of 0.914 g/cm³ and a weight of 100 kg, and the resultant was sufficiently kneaded, thereby preparing an LLDPE resin composition. This prepared LLDPE resin composition was extruded by means of an extruder, thereby preparing a first film 11 having a thickness of 60 µm and a content of the inorganic ultraviolet absorbing agent of 20% by mass. One side of the first film 11 was subjected to corona treatment.

A PET film (manufactured by TOYOBO Co., Ltd. and having a product name: TOYOBO ESTER FILM E5000), as a film excellent in electrical insulating properties, having a thickness of 125 µm and a PVF film (manufactured by DuPont Co., Ltd. and having a product name: Tedlar), as a film excellent in weather resistance, having a thickness of 38 µm were prepared. These films were laminated, thereby preparing a second film 12.

A side of the one side of the first film 11, subjected to the corona treatment, and a side of the PET film of the second film 12 were bonded by using a dry laminating adhesive and employing a dry lamination method. As the dry laminating adhesive, a urethane adhesive that was a mixture of a product named "TAKELAC A315" (100 parts by weight) and a product named "TAKENATE A50" (10 parts by weight), both of which were manufactured by Mitsui Chemicals Polyurethanes Co., Ltd., was used with a solid content coated amount of 3 g/m². As described above, a back side protective sheet 10 for a solar cell as an example according to the present invention was prepared.

### (Example 2)

Titanium oxide (TiO₂) particles, as an inorganic ultraviolet absorbing agent, having an average particle diameter of 0.3 µm and a weight of 0.2 kg were added to a polyethylene resin (manufactured by Tamapoly Co., Ltd.) having a density of 0.914 g/cm³ and a weight of 100 kg, and the resultant was sufficiently kneaded, thereby preparing an LLDPE resin composition. This prepared LLDPE resin composition was extruded by means of an extruder, thereby preparing a first film 11 having a thickness of 100 µm and a content of the inorganic ultraviolet absorbing agent of 0.2% by mass. One side of the first film 11 was subjected to corona treatment.

A PET film (manufactured by TOYOBO Co., Ltd. and having a product name: TOYOBO ESTER FILM E5000), as a film excellent in electrical insulating properties, having a thickness of 125 µm and a PVF film (manufactured by DuPont Co., Ltd. and having a product name: Tedlar), as a film excellent in weather resistance, having a thickness of 38 µm were prepared. These films were laminated, thereby preparing a second film 12.

A side of the one side of the first film 11, subjected to the corona treatment, and a side of the PET film of the second film 12 were bonded by using a dry laminating adhesive and employing a dry lamination method. As the dry laminating adhesive, a urethane adhesive that was a mixture of a product named "TAKELAC A315" (100 parts by weight) and a product named "TAKENATE A50" (10 parts by weight), both of which were manufactured by Mitsui Chemicals Polyurethanes Co., Ltd., was used with a solid content coated amount of 3 g/m². As described above, a back side protective sheet 10 for a solar cell as an example according to the present invention was prepared.

### (Example 3)

Titanium oxide (TiO₂) particles, as an inorganic ultraviolet absorbing agent, having an average particle diameter of 0.3 µm and a weight of 0.1 kg kg were added to a polyethylene resin (manufactured by Tamapoly Co., Ltd.) having a density of 0.914 g/cm³ and a weight of 100 kg, and the resultant was sufficiently kneaded, thereby preparing an LLDPE resin composition. This prepared LLDPE resin composition was extruded by means of an extruder, thereby preparing a first film 11 having a thickness of 150 µm and a content of the inorganic ultraviolet absorbing agent of 0.1% by mass. One side of the first film 11 was subjected to corona treatment.

A PET film (manufactured by TOYOBO Co., Ltd. and having a product name: TOYOBO ESTER FILM E5000), as a film excellent in electrical insulating properties, having a thickness of 125 µm and a PVF film (manufactured by DuPont Co., Ltd. and having a product name: Tedlar), as a film excellent in weather resistance, having a thickness of 38 µm were prepared. These films were laminated, thereby preparing a second film 12.

A side of the one side of the first film 11, subjected to the corona treatment, and a side of the PET film of the second film 12 were bonded by using a dry laminating adhesive and employing a dry lamination method. As the dry laminating adhesive, a urethane adhesive that was a mixture of a product named "TAKELAC A315" (100 parts by weight) and a product named "TAKENATE A50" (10 parts by weight), both of which were manufactured by Mitsui Chemicals Polyurethanes Co., Ltd., was used with a solid content coated amount of 3 g/m². As described above, a back side protective sheet 10 for a solar cell as an example according to the present invention was prepared.

### (Example 4)

Titanium oxide (TiO₂) particles, as an inorganic ultraviolet absorbing agent, having an average particle diameter of 0.2 µm and a weight of 25 kg were added to a polyethylene resin (manufactured by Tamapoly Co., Ltd.) having a density of 0.914 g/cm³ and a weight of 100 kg, and the resultant was sufficiently kneaded, thereby preparing an LLDPE resin composition. This prepared LLDPE resin composition was extruded by means of an extruder, thereby preparing a first film 11 having a thickness of 60 µm and a content of the inorganic ultraviolet absorbing agent of 20% by mass. One side of the first film 11 was subjected to corona treatment.

A PET film (manufactured by TOYOBO Co., Ltd. and having a product name: TOYOBO ESTER FILM E5000), as a film excellent in electrical insulating properties, having a thickness of 125 µm and a PVDF film (manufactured by DENKI KAGAKU KOGYO KABUSHIKI KAISHA), as a film excellent in weather resistance, having a thickness of 40 µm were prepared. These films were laminated, thereby preparing a second film 12.

A side of the one side of the first film 11, subjected to the corona treatment, and a side of the PET film of the second film 12 were bonded by using a dry laminating adhesive and employing a dry lamination method. As the dry laminating adhesive, a urethane adhesive that was a mixture of a product named "TAKELAC A315" (100 parts by weight) and a product named "TAKENATE A50" (10 parts by weight), both of which were manufactured by Mitsui Chemicals Polyurethanes Co., Ltd., was used with a solid content coated amount of 3 g/m². As described above, a back side protective sheet 10 for a solar cell as an example according to the present invention was prepared.

### (Example 5)

Titanium oxide (TiO₂) particles, as an inorganic ultraviolet absorbing agent, having an average particle diameter of 0.2 µm and a weight of 25 kg were added to a polyethylene resin (manufactured by Tamapoly Co., Ltd.) having a density of 0.914 g/cm³ and a weight of 100 kg, and the resultant was sufficiently kneaded, thereby preparing an LLDPE resin composition. This prepared LLDPE resin composition was extruded by means of an extruder, thereby preparing a first film 11 having a thickness of 100 µm and a content of the inorganic ultraviolet absorbing agent of 20% by mass. One side of the first film 11 was subjected to corona treatment.

A PET film (manufactured by TOYOBO Co., Ltd. and having a product name: TOYOBO ESTER FILM E5000), as a film excellent in electrical insulating properties, having a thickness of 125 µm and a PVDF film (manufactured by DENKI KAGAKU KOGYO KABUSHIKI KAISHA), as a film excellent in weather resistance, having a thickness of 40 µm were prepared. These films were laminated, thereby preparing a second film 12.

A side of the one side of the first film 11, subjected to the corona treatment, and a side of the PET film of the second film 12 were bonded by using a dry laminating adhesive and employing a dry lamination method. As the dry laminating adhesive, a urethane adhesive that was a mixture of a product named "TAKELAC A315" (100 parts by weight) and a product named "TAKENATE A50" (10 parts by weight), both of which were manufactured by Mitsui Chemicals Polyurethanes Co., Ltd., was used with a solid content coated amount of 3 g/m². As described above, a back side protective sheet 10 for a solar cell as an example according to the present invention was prepared.

### (Example 6)

Titanium oxide (TiO₂) particles, as an inorganic ultraviolet absorbing agent, having an average particle diameter of 0.2 µm and a weight of 0.5 kg were added to a polyethylene resin (manufactured by Tamapoly Co., Ltd.) having a density of 0.914 g/cm³ and a weight of 100 kg, and the resultant was sufficiently kneaded, thereby preparing an LLDPE resin composition. This prepared LLDPE resin composition was extruded by means of an extruder, thereby preparing a first film 11 having a thickness of 150 µm and a content of the inorganic ultraviolet absorbing agent of 0.5% by mass. One side of the first film 11 was subjected to corona treatment.

A PET film (manufactured by TOYOBO Co., Ltd. and having a product name: TOYOBO ESTER FILM E5000), as a film excellent in electrical insulating properties, having a thickness of 125 µm and a PVDF film (manufactured by DENKI KAGAKU KOGYO KABUSHIKI KAISHA), as a film excellent in weather resistance, having a thickness of 40 µm were prepared. These films were laminated, thereby preparing a second film 12.

A side of the one side of the first film 11, subjected to the corona treatment, and a side of the PET film of the second film 12 were bonded by using a dry laminating adhesive and employing a dry lamination method. As the dry laminating adhesive, a urethane adhesive that was a mixture of a product named "TAKELAC A315" (100 parts by weight) and a product named "TAKENATE A50" (10 parts by weight), both of which were manufactured by Mitsui Chemicals Polyurethanes Co., Ltd., was used with a solid content coated amount of 3 g/m². As described above, a back side protective sheet 10 for a solar cell as an example according to the present invention was prepared.

### (Example 7)

Titanium oxide (TiO₂) particles, as an inorganic ultraviolet absorbing agent, having an average particle diameter of 0.3 µm and a weight of 43 kg were added to a polyethylene resin (manufactured by Tamapoly Co., Ltd.) having a density of 0.914 g/cm³ and a weight of 100 kg, and the resultant was sufficiently kneaded, thereby preparing an LLDPE resin composition. This prepared LLDPE resin composition was extruded by means of an extruder, thereby preparing a first film 11 having a thickness of 60 µm and a content of the inorganic ultraviolet absorbing agent of 30% by mass. One side of the first film 11 was subjected to corona treatment.

A PET film (manufactured by TOYOBO Co., Ltd. and having a product name: TOYOBO ESTER FILM E5000), as a film excellent in electrical insulating properties, having a thickness of 125 µm and a PVF film (manufactured by DuPont Co., Ltd. and having a product name: Tedlar), as a film excellent in weather resistance, having a thickness of 38 µm were prepared. These films were laminated, thereby preparing a second film 12.

A side of the one side of the first film 11, subjected to the corona treatment, and a side of the PET film of the second film 12 were bonded by using a dry laminating adhesive and employing a dry lamination method. As the dry laminating adhesive, a urethane adhesive that was a mixture of a product named "TAKELAC A315" (100 parts by weight) and a product named "TAKENATE A50" (10 parts by weight), both of which were manufactured by Mitsui Chemicals Polyurethanes Co., Ltd., was used with a solid content coated amount of 3 g/m². As described above, a back side protective sheet 10 for a solar cell as an example according to the present invention was prepared.

### (Example 8)

Calcium carbonate (CaCO₃) particles, as an inorganic ultraviolet absorbing agent, having an average particle diameter of 5 µm and a weight of 43 kg were added to a polyethylene resin (manufactured by Tamapoly Co., Ltd.) having a density of 0.914 g/cm³ and a weight of 100 kg, and the resultant was sufficiently kneaded, thereby preparing an LLDPE resin composition. This prepared LLDPE resin composition was extruded by means of an extruder, thereby preparing a first film 11 having a thickness of 60 µm and a content of the inorganic ultraviolet absorbing agent of 30% by mass. One side of the first film 11 was subjected to corona treatment.

A PET film (manufactured by TOYOBO Co., Ltd. and having a product name: TOYOBO ESTER FILM E5000), as a film excellent in electrical insulating properties, having a thickness of 125 µm and a PVF film (manufactured by DuPont Co., Ltd. and having a product name: Tedlar), as a film excellent in weather resistance, having a thickness of 38 µm were prepared. These films were laminated, thereby preparing a second film 12.

A side of the one side of the first film 11, subjected to the corona treatment, and a side of the PET film of the second film 12 were bonded by using a dry laminating adhesive and employing a dry lamination method. As the dry laminating adhesive, a urethane adhesive that was a mixture of a product named "TAKELAC A315" (100 parts by weight) and a product named "TAKENATE A50" (10 parts by weight), both of which were manufactured by Mitsui Chemicals Polyurethanes Co., Ltd., was used with a solid content coated amount of 3 g/m². As described above, a back side protective sheet 10 for a solar cell as an example according to the present invention was prepared.

### (Example 9)

Zinc oxide (ZnO) particles, as an inorganic ultraviolet absorbing agent, having an average particle diameter of 0.3 µm and a weight of 11 kg were added to a polyethylene resin (manufactured by Tamapoly Co., Ltd.) having a density of 0.914 g/cm³ and a weight of 100 kg, and the resultant was sufficiently kneaded, thereby preparing an LLDPE resin composition. This prepared LLDPE resin composition was extruded by means of an extruder, thereby preparing a first film 11 having a thickness of 60 µm and a content of the inorganic ultraviolet absorbing agent of 10% by mass. One side of the first film 11 was subjected to corona treatment.

A PET film (manufactured by TOYOBO Co., Ltd. and having a product name: TOYOBO ESTER FILM E5000), as a film excellent in electrical insulating properties, having a thickness of 125 µm and a PVF film (manufactured by DuPont Co., Ltd. and having a product name: Tedlar), as a film excellent in weather resistance, having a thickness of 38 µm were prepared. These films were laminated, thereby preparing a second film 12.

A side of the one side of the first film 11, subjected to the corona treatment, and a side of the PET film of the second film 12 were bonded by using a dry laminating adhesive and employing a dry lamination method. As the dry laminating adhesive, a urethane adhesive that was a mixture of a product named "TAKELAC A315" (100 parts by weight) and a product named "TAKENATE A50" (10 parts by weight), both of which were manufactured by Mitsui Chemicals Polyurethanes Co., Ltd., was used with a solid content coated amount of 3 g/m². As described above, a back side protective sheet 10 for a solar cell as an example according to the present invention was prepared.

### (Example 10)

Zinc oxide (ZnO) particles, as an inorganic ultraviolet absorbing agent, having an average particle diameter of 0.3 µm and a weight of 43 kg were added to a polyethylene resin (manufactured by Tamapoly Co., Ltd.) having a density of 0.914 g/cm³ and a weight of 100 kg, and the resultant was sufficiently kneaded, thereby preparing an LLDPE resin composition. This prepared LLDPE resin composition was extruded by means of an extruder, thereby preparing a first film 11 having a thickness of 60 µm and a content of the inorganic ultraviolet absorbing agent of 30% by mass. One side of the first film 11 was subjected to corona treatment.

A PET film (manufactured by TOYOBO Co., Ltd. and having a product name: TOYOBO ESTER FILM E5000), as a film excellent in electrical insulating properties, having a thickness of 125 µm and a PVF film (manufactured by DuPont Co., Ltd. and having a product name: Tedlar), as a film excellent in weather resistance, having a thickness of 38 µm were prepared. These films were laminated, thereby preparing a second film 12.

A side of the one side of the first film 11, subjected to the corona treatment, and a side of the PET film of the second film 12 were bonded by using a dry laminating adhesive and employing a dry lamination method. As the dry laminating adhesive, a urethane adhesive that was a mixture of a product named "TAKELAC A315" (100 parts by weight) and a product named "TAKENATE A50" (10 parts by weight), both of which were manufactured by Mitsui Chemicals Polyurethanes Co., Ltd., was used with a solid content coated amount of 3 g/m². As described above, a back side protective sheet 10 for a solar cell as an example according to the present invention was prepared.

### (Comparison Example 1)

Particles of 2,4-dihydroxybenzophenone, as an organic ultraviolet absorbing agent, having an average particle diameter of 0.3 µm and a weight of 3.1 kg were added to a polyethylene resin (manufactured by Tamapoly Co., Ltd.) having a density of 0.914 g/cm³ and a weight of 100 kg, and the resultant was sufficiently kneaded, thereby preparing an LLDPE resin composition. This prepared LLDPE resin composition was extruded by means of an extruder, thereby preparing a first film 11 having a thickness of 60 µm and a content of the inorganic ultraviolet absorbing agent of 3% by mass. One side of the first film 11 was subjected to corona treatment.

A PET film (manufactured by TOYOBO Co., Ltd. and having a product name: TOYOBO ESTER FILM E5000), as a film excellent in electrical insulating properties, having a thickness of 125 µm and a PVF film (manufactured by DuPont Co., Ltd. and having a product name: Tedlar), as a film excellent in weather resistance, having a thickness of 38 µm were prepared. These films were laminated, thereby preparing a second film 12.

A side of the one side of the first film 11, subjected to the corona treatment, and a side of the PET film of the second film 12 were bonded by using a dry laminating adhesive and employing a dry lamination method. As the dry laminating adhesive, a urethane adhesive that was a mixture of a product named "TAKELAC A315" (100 parts by weight) and a product named "TAKENATE A50" (10 parts by weight), both of which were manufactured by Mitsui Chemicals Polyurethanes Co., Ltd., was used with a solid content coated amount of 3 g/m². As described above, a back side protective sheet 10 for a solar cell as a comparison example of the present invention was prepared.

### (Comparison Example 2)

A polyethylene resin (manufactured by Tamapoly Co., Ltd.) having a density of 0.914 g/cm³ was extruded by means of an extruder, thereby preparing a first film 11 having a thickness of 60 µm. One side of the first film 11 was subjected to corona treatment.

A PET film (manufactured by TOYOBO Co., Ltd. and having a product name: TOYOBO ESTER FILM E5000), as a film excellent in electrical insulating properties, having a thickness of 125 µm and a PVF film (manufactured by DuPont Co., Ltd. and having a product name: Tedlar), as a film excellent in weather resistance, having a thickness of 38 µm were prepared. These films were laminated, thereby preparing a second film 12.

A side of the one side of the first film 11, subjected to the corona treatment, and a side of the PET film of the second film 12 were bonded by using a dry laminating adhesive and employing a dry lamination method. As the dry laminating adhesive, a urethane adhesive that was a mixture of a product named "TAKELAC A315" (100 parts by weight) and a product named "TAKENATE A50" (10 parts by weight), both of which were manufactured by Mitsui Chemicals Polyurethanes Co., Ltd., was used with a solid content coated amount of 3 g/m². As described above, a back side protective sheet 10 for a solar cell as a comparison example of the present invention was prepared.

### (Comparison Example 3)

Titanium oxide (TiO₂) particles, as an inorganic ultraviolet absorbing agent, having an average particle diameter of 0.3 µm and a weight of 5 g were added to a polyethylene resin (manufactured by Tamapoly Co., Ltd.) having a density of 0.914 g/cm³ and a weight of 100 kg, and the resultant was sufficiently kneaded, thereby preparing an LLDPE resin composition. This prepared LLDPE resin composition was extruded by means of an extruder, thereby preparing a first film 11 having a thickness of 60 µm and a content of the inorganic ultraviolet absorbing agent of 0.005% by mass. One side of the first film 11 was subjected to corona treatment.

A PET film (manufactured by TOYOBO Co., Ltd. and having a product name: TOYOBO ESTER FILM E5000), as a film excellent in electrical insulating properties, having a thickness of 125 µm and a PVF film (manufactured by DuPont Co., Ltd. and having a product name: Tedlar), as a film excellent in weather resistance, having a thickness of 38 µm were prepared. These films were laminated, thereby preparing a second film 12.

A side of the one side of the first film 11, subjected to the corona treatment, and a side of the PET film of the second film 12 were bonded by using a dry laminating adhesive and employing a dry lamination method. As the dry laminating adhesive, a urethane adhesive that was a mixture of a product named "TAKELAC A315" (100 parts by weight) and a product named "TAKENATE A50" (10 parts by weight), both of which were manufactured by Mitsui Chemicals Polyurethanes Co., Ltd., was used with a solid content coated amount of 3 g/m². As described above, a back side protective sheet 10 for a solar cell as a comparison example of the present invention was prepared.

### (Comparison Example 4)

Titanium oxide (TiO₂) particles, as an inorganic ultraviolet absorbing agent, having an average particle diameter of 0.3 µm and a weight of 45 kg were added to a polyethylene resin (manufactured by Tamapoly Co., Ltd.) having a density of 0.914 g/cm³ and a weight of 100 kg, and the resultant was sufficiently kneaded, thereby preparing an LLDPE resin composition. This prepared LLDPE resin composition was extruded by means of an extruder, thereby preparing a first film 11 having a thickness of 30 µm and a content of the inorganic ultraviolet absorbing agent of 31% by mass. One side of the first film 11 was subjected to corona treatment.

A PET film (manufactured by TOYOBO Co., Ltd. and having a product name: TOYOBO ESTER FILM E5000), as a film excellent in electrical insulating properties, having a thickness of 125 µm and a PVF film (manufactured by DuPont Co., Ltd. and having a product name: Tedlar), as a film excellent in weather resistance, having a thickness of 38 µm were prepared. These films were laminated, thereby preparing a second film 12.

A side of the one side of the first film 11, subjected to the corona treatment, and a side of the PET film of the second film 12 were bonded by using a dry laminating adhesive and employing a dry lamination method. As the dry laminating adhesive, a urethane adhesive that was a mixture of a product named "TAKELAC A315" (100 parts by weight) and a product named "TAKENATE A50" (10 parts by weight), both of which were manufactured by Mitsui Chemicals Polyurethanes Co., Ltd., was used with a solid content coated amount of 3 g/m². As described above, a back side protective sheet 10 for a solar cell as a comparison example of the present invention was prepared.

### (Comparison Example 5)

Titanium oxide (TiO₂) particles, as an inorganic ultraviolet absorbing agent, having an average particle diameter of 0.05 µm and a weight of 100 g were added to a polyethylene resin (manufactured by Tamapoly Co., Ltd.) having a density of 0.914 g/cm³ and a weight of 100 kg, and the resultant was sufficiently kneaded, thereby preparing an LLDPE resin composition. This prepared LLDPE resin composition was extruded by means of an extruder, thereby preparing a first film 11 having a thickness of 30 µm and a content of the inorganic ultraviolet absorbing agent of 0.1% by mass. One side of the first film 11 was subjected to corona treatment.

A PET film (manufactured by TOYOBO Co., Ltd. and having a product name: TOYOBO ESTER FILM E5000), as a film excellent in electrical insulating properties, having a thickness of 125 µm and a PVF film (manufactured by DuPont Co., Ltd. and having a product name: Tedlar), as a film excellent in weather resistance, having a thickness of 38 µm were prepared. These films were laminated, thereby preparing a second film 12.

A side of the one side of the first film 11, subjected to the corona treatment, and a side of the PET film of the second film 12 were bonded by using a dry laminating adhesive and employing a dry lamination method. As the dry laminating adhesive, a urethane adhesive that was a mixture of a product named "TAKELAC A315" (100 parts by weight) and a product named "TAKENATE A50" (10 parts by weight), both of which were manufactured by Mitsui Chemicals Polyurethanes Co., Ltd., was used with a solid content coated amount of 3 g/m². As described above, a back side protective sheet 10 for a solar cell as a comparison example of the present invention was prepared.

### (Comparison Example 6)

Titanium oxide (TiO₂) particles, as an inorganic ultraviolet absorbing agent, having an average particle diameter of 6 µm and a weight of 100 g were added to a polyethylene resin (manufactured by Tamapoly Co., Ltd.) having a density of 0.914 g/cm³ and a weight of 100 kg, and the resultant was sufficiently kneaded, thereby preparing an LLDPE resin composition. This prepared LLDPE resin composition was extruded by means of an extruder, thereby preparing a first film 11 having a thickness of 30 µm and a content of the inorganic ultraviolet absorbing agent of 0.1% by mass. One side of the first film 11 was subjected to corona treatment.

A PET film (manufactured by TOYOBO Co., Ltd. and having a product name: TOYOBO ESTER FILM E5000), as a film excellent in electrical insulating properties, having a thickness of 125 µm and a PVF film (manufactured by DuPont Co., Ltd. and having a product name: Tedlar), as a film excellent in weather resistance, having a thickness of 38 µm were prepared. These films were laminated, thereby preparing a second film 12.

A side of the one side of the first film 11, subjected to the corona treatment, and a side of the PET film of the second film 12 were bonded by using a dry laminating adhesive and employing a dry lamination method. As the dry laminating adhesive, a urethane adhesive that was a mixture of a product named "TAKELAC A315" (100 parts by weight) and a product named "TAKENATE A50" (10 parts by weight), both of which were manufactured by Mitsui Chemicals Polyurethanes Co., Ltd., was used with a solid content coated amount of 3 g/m². As described above, a back side protective sheet 10 for a solar cell as a comparison example of the present invention was prepared.

Yellow discoloration of each of the back side protective sheets 10 for solar cells prepared as described above; and ultraviolet transmittance and yellow discoloration of each of the first films 11 thereof were evaluated as described below.

### (Ultraviolet Transmittance of First Film)

An ultraviolet transmittance of each of the first films 11 was obtained as follows. First, by using a multi-purpose spectrophotometer manufactured by JASCO Corporation, each of the first films 11 was irradiated with ultraviolet rays each having a wavelength of 300 through 600 nm, and a transmittance in a range of these wavelengths was measured. Next, a transmittance with respect to a wavelength of 350 nm was measured and evaluated as the ultraviolet transmittance.

### (Yellow Discoloration I)

A side of each of the first films 11 of the obtained back side protective sheets 10 for solar cells was irradiated with ultraviolet rays. The side thereof was irradiated with the ultraviolet rays under the irradiation conditions of 100 mW/cm² and 15 hours by using a metal halide lamp "EYE Super UV Tester SUV-W151 (manufactured by Iwasaki Electric Co., Ltd.)". Yellow discoloration after the irradiation of the ultraviolet rays was evaluated by using a value Δb* which was measured from the side of each of the first films 11. The value Δb* indicates a difference between a value b* before the irradiation and a value b* after the irradiation. This value Δb* was evaluated as "yellow discoloration I". In order to measure the values b*, a colorimeter, Multi-Angle Spectrophotometer X-Rite MA68II model manufactured by X-Rite, Incorporated, was used.

### (Yellow Discoloration II)

The test samples used for the evaluation of the yellow discoloration I were retained at a temperature of 85C° in an atmosphere of a relative humidity of 85% for 3000 hours, and thereafter, in a manner similar to the manner in which the yellow discoloration I was evaluated, yellow discoloration was evaluated by using a value Δb* which was measured from the side of each of the first films 11. The value Δb* indicates a difference between the value b* before the irradiation, used for the evaluation of the yellow discoloration I, and a value b* after the irradiation and after the retaining for 3000 hours. This value Δb* was evaluated as "yellow discoloration II".

### (Adhesive Strength)

By using the obtained back side protective sheets 10 for solar cells, dummy solar cell modules were prepared. Specifically, each of the dummy solar cell modules was prepared by laminating in order an EVA resin (manufactured by Bridgestone Corporation and having a product name: S-11) having a thickness of 0.5 mm and an area of 20 cm × 20 cm and each of the back side protective sheets 10 for solar cells, obtained in Examples 1 through 10 and Comparison Examples 1 through 6, having an area of 20 cm × 20 cm on a glass plate having a thickness of 3 mm and an area of 20 cm × 20 cm so as to superpose respective sides on one another. These laminated bodies were subjected to defoaming processing at a temperature of 150C° for 5 minutes and pressurized at a temperature of 150C° for 15 minutes by using an atmospheric press, thereby preparing the dummy solar cell modules.

A test specimen which had one open portion and a width of 15 mm was prepared by making, from a surface side of each of the back side protective sheets 10 for solar cells of the dummy solar cell modules toward each of the EVA resins, a cut which had a depth of (a thickness of each of the back side protective sheets 10 for solar cells + 5 µm), a width of 15 mm, and a length of 18 cm, and the test specimen was pulled at a pulling speed of 100 mm/minute. At this time, rupture stress values were measured and each of the rupture stress values was evaluated as an adhesion force (N/15 mm) between each of the EVA resins and each of the back side protective sheets 10 for solar cells. Here, in a case where this rupture stress value exceeds 40 (N/15 mm), a rupture of each of the back side protective sheets occurs before an exfoliation between each of the EVA resin and each of the back side protective sheets occurs. Therefore, an accurate adhesion force cannot be evaluated. In such a case, an adhesion force was evaluated as being 40 (N/15 mm) or more.

The results obtained as above are shown in Table 1 and Table 2.

**[Table 1]**

| | First Film | | | | | | Second Film | Total Thickness (µm) |
|---|---|---|---|---|---|---|---|---|
| | | | Ultraviolet Absorbing Agent | | | Ultraviolet Transmittance | | |
| | Material | Thickness | Material | Content | Particle Diameter | | Material | |
| | | (µm) | | (% by mass) | (µm) | (%) | [Numerical Value = Thickness (µm)] | |
| Comparison Example 1 | LLDPE | 60 | 2,4-dihydroxybenzophenone | 3 | 0.3 | 10 | 125PET+38PVF | 229 |
| Comparison Example 2 | LLDPE | 60 | None | | | 85 | 125PET+38PVF | 229 |
| Comparison Example 3 | LLDPE | 60 | TiO₂ | 0.005 | 0.3 | 80 | 125PET+38PVF | 229 |
| Comparison Example 4 | LLDPE | 30 | TiO₂ | 31 | 0.3 | < 1 | 125PET+38PVF | 199 |
| Comparison Example 5 | LLDPE | 30 | TiO₂ | 0.1 | 0.05 | 82 | 125PET+38PVF | 199 |
| Comparison Example 6 | LLDPE | 30 | TiO₂ | 0.1 | 6 | 78 | 125PET+38PVF | 199 |
| Example 1 | LLDPE | 60 | TiO₂ | 20 | 0.3 | < 1 | 125PET+38PVF | 229 |
| Example 2 | LLDPE | 100 | TiO₂ | 0.2 | 0.3 | 15 | 125PET+38PVF | 269 |
| Example 3 | LLDPE | 150 | TiO₂ | 0.1 | 0.3 | 18 | 125PET+38PVF | 319 |
| Example 4 | LLDPE | 60 | TiO₂ | 20 | 0.2 | < 1 | 125PET+40PVDF | 231 |
| Example 5 | LLDPE | 100 | TiO₂ | 20 | 0.2 | < 1 | 125PET+40PVDF | 271 |
| Example 6 | LLDPE | 150 | TiO₂ | 0.5 | 0.2 | < 1 | 125PET+40PVDF | 321 |
| Example 7 | LLDPE | 60 | TiO₂ | 30 | 0.3 | < 1 | 125PET+38PVF | 229 |
| Example 8 | LLDPE | 60 | CaCO₃ | 30 | 5 | 10 | 125PET+38PVF | 229 |
| Example 9 | LLDPE | 60 | ZnO | 10 | 0.3 | 7 | 125PET+38PVF | 229 |
| Example 10 | LLDPE | 60 | ZnO | 30 | 0.3 | 3 | 125PET+38PVF | 229 |

**[Table 2]**

| | Back Side Protective Sheet | | Dummy Solar Cell Module |
|---|---|---|---|
| | Yellow Discoloration I Δb* | Yellow Discoloration II Δb* | Adhesion Force (N/15 mm) |
| Comparison Example 1 | 5.1 | 15.4 | 40 or more |
| Comparison Example 2 | 38.6 | - | 40 or more |
| Comparison Example 3 | 33.3 | - | 40 or more |
| Comparison Example 4 | 0.3 | 0.4 | 35 |
| Comparison Example 5 | 31.5 | - | 40 or more |
| Comparison Example 6 | 28.6 | - | 40 or more |
| Example 1 | 0.4 | 0.4 | 40 or more |
| Example 2 | 11.1 | 11.5 | 40 or more |
| Example 3 | 10.1 | 10.8 | 40 or more |
| Example 4 | 0.3 | 0.3 | 40 or more |
| Example 5 | 0.3 | 0.3 | 40 or more |
| Example 6 | 0.3 | 0.3 | 40 or more |
| Example 7 | 0.3 | 0.3 | 40 or more |
| Example 8 | 4.2 | 4.5 | 40 or more |
| Example 9 | 2.1 | 2.2 | 40 or more |
| Example 10 | 0.5 | 0.6 | 40 or more |

From the results shown in Table 1 and Table 2, it can be seen that each of the examples according to the present invention is capable of enhancing the adherence to the EVA resin as the filler used to seal the solar cell elements and of preventing the yellow discoloration over a long period of time.

### INDUSTRIAL APPLICABILITY

A back side protective sheet for a solar cell according to the present invention is used so as to be disposed on a back side of a solar cell module and is capable of enhancing adherence to an EVA resin as a filler used to seal solar cell elements and of preventing yellow discoloration a long period of time.

### REFERENCE SIGNS LIST

10: back side protective sheet for a solar cell, 11: first film, 12: second film, 100: solar cell module.

## Claims

1. A back side protective sheet (10) for a solar cell, being disposed on a back side of a solar cell module (100), comprising:
a first film (11) containing linear low-density polyethylene having a density greater than or equal to 0.91 g/cm³ and less than or equal to 0.93 g/cm³ and an inorganic ultraviolet absorbing agent; and
a second film (12) being laminated on the first film (11), with a urethane adhesive layer being interposed therebetween,
the inorganic ultraviolet absorbing agent having an average particle diameter greater than or equal to 0.1 µm and less than or equal to 5 µm,
the first film (11) containing the inorganic ultraviolet absorbing agent greater than or equal to 0.1% by mass and less than or equal to 30% by mass.

2. The back side protective sheet (10) for a solar cell according to claim 1, wherein the inorganic ultraviolet absorbing agent is one kind selected from the group consisting of a titanium oxide, a zinc oxide, a zirconium oxide, a calcium carbonate, a cerium oxide, silica, an iron oxide, and carbon.

3. The back side protective sheet (10) for a solar cell according to claim 1, wherein an ultraviolet transmittance of the first film (11) is less than or equal to 20%.

4. The back side protective sheet (10) for a solar cell according to claim 1, wherein a thickness of the first film (11) is greater than or equal to 5 µm and less than or equal to 200 µm.

5. The back side protective sheet (10) for a solar cell according to claim 1, wherein the second film (12) includes: polyethylene terephthalate being disposed on a side of the first film (11); and a fluorine-based film being laminated on the polyethylene terephthalate film.

6. A solar cell module (100) comprising:
a filler (7) being constituted of an ethylene-vinyl acetate copolymer resin being disposed to seal solar cell elements (1); and
the back side protective sheet (10) for a solar cell according to claim 1 being fixedly attached on an outer surface of the filler (7) of a back side of the solar cell module (100).

## Patentansprüche

1. Rückseitenschutzfolie (10) für eine Solarzelle, die auf einer Rückseite eines Solarzellenmoduls (100) angeordnet ist, umfassend:
einen ersten Film (11), der lineares Polyethylen niedriger Dichte mit einer Dichte größer als oder gleich 0,91 g/cm³ und kleiner als oder gleich 0,93 g/cm³ und ein anorganisches ultraviolett-absorbierendes Mittel enthält; und
einen zweiten Film (12), der auf den ersten Film (11) laminiert ist, mit einer dazwischen eingefügten Urethanklebstoffschicht,
wobei das anorganische ultraviolett-absorbierende Mittel einen mittleren Teilchendurchmesser größer als oder gleich 0,1 µm und kleiner als oder gleich 5 µm aufweist,
wobei der erste Film (11) das anorganische ultraviolett-absorbierende Mittel in einer Menge größer als oder gleich 0,1 Massenprozent und kleiner als oder gleich 30 Massenprozent enthält.

2. Rückseitenschutzfolie (10) für eine Solarzelle gemäß Anspruch 1, wobei das anorganische ultraviolett-absorbierende Mittel eine Art, ausgewählt aus der Gruppe bestehend aus einem Titanoxid, einem Zinkoxid, einem Zirconiumoxid, einem Calciumcarbonat, einem Ceroxid, Siliciumdioxid, einem Eisenoxid und Kohlenstoff, ist.

3. Rückseitenschutzfolie (10) für eine Solarzelle gemäß Anspruch 1, wobei eine Ultraviolettdurchlässigkeit des ersten Films (11) kleiner als oder gleich 20 % ist.

4. Rückseitenschutzfolie (10) für eine Solarzelle gemäß Anspruch 1, wobei eine Dicke des ersten Films (11) größer als oder gleich 5 µm und kleiner als oder gleich 200 µm ist.

5. Rückseitenschutzfolie (10) für eine Solarzelle gemäß Anspruch 1, wobei der zweite Film (12) folgendes einschließt: Polyethylenterephthalat, das auf einer Seite des ersten Films (11) angeordnet ist; und einen Film auf Fluorbasis, der auf den Polyethylenterephthalatfilm laminiert ist.

6. Solarzellenmodul (100) umfassend:
einen Füllstoff (7), der aus einem Ethylen-Vinylacetat-Copolymerharz gebildet ist und zum Versiegeln von Solarzellenelementen (1) angeordnet ist; und
die Rückseitenschutzfolie (10) für eine Solarzelle gemäß Anspruch 1, die unbeweglich an einer äußeren Oberfläche des Füllstoffs (7) von einer Rückseite des Solarzellenmoduls (100) befestigt ist.

## Revendications

1. Feuille dorsale protectrice (10) destinée à une pile solaire, disposée sur une face arrière d'un module de pile solaire (100), comprenant :
un premier film (11) contenant un polyéthylène linéaire basse densité présentant une densité supérieure ou égale à 0,91 g/cm³ et inférieure ou égale à 0,93 g/cm³ et un agent inorganique d'absorption du rayonnement ultraviolet ; et
un second film (12) stratifié sur le premier film (11), présentant une couche adhésive d'uréthane interposée entre eux,
l'agent inorganique d'absorption du rayonnement ultraviolet présentant un diamètre moyen de particule supérieur ou égal à 0,1 µm et inférieur ou égal à 5 µm,
le premier film (11) contenant l'agent inorganique d'absorption du rayonnement ultraviolet en une quantité supérieure ou égale à 0,1 % en masse et inférieure ou égale à 30 % en masse.

2. Feuille dorsale protectrice (10) destinée à une pile solaire selon la revendication 1, l'agent inorganique d'absorption du rayonnement ultraviolet étant un type sélectionné dans le groupe constitué d'un oxyde de titane, d'un oxyde de zinc, d'un oxyde de zirconium, d'un carbonate de calcium, d'un oxyde de cérium, de silice, d'un oxyde de fer, et de carbone.

3. Feuille dorsale protectrice (10) destinée à une pile solaire selon la revendication 1, une transmittance du rayonnement ultraviolet du premier film (11) étant inférieure ou égale à 20 %.

4. Feuille dorsale protectrice (10) destinée à une pile solaire selon la revendication 1, une épaisseur du premier film (11) étant supérieure ou égale à 5 µm et inférieure ou égale à 200 µm.

5. Feuille dorsale protectrice (10) destinée à une pile solaire selon la revendication 1, le second film (12) comprenant : du poly(téréphtalate d'éthylène) disposé sur une face du premier film (11) ; et un film à base de fluor stratifié sur le film de poly(téréphtalate d'éthylène).

6. Module de pile solaire (100) comprenant :
un garnissage (7) constitué d'une résine copolymère d'éthylène-acétate de vinyle disposé pour hermétiquement sceller les éléments de pile solaire (1) ; et
la feuille dorsale protectrice (10) destinée à une pile solaire selon la revendication 1 étant attachée de manière fixe sur une surface externe du garnissage (7) d'une face arrière du module de pile solaire (100).
